# EUROPEAN PATENT APPLICATION

(11) **EP 2 728 023 A1**
(43) Date of publication of application: **07.05.2014**
(21) Application number: 11868798.7
(22) Date of filing: 15.09.2011
(51) Int. Cl.: C22B 59/00, C22B 9/02, C22C 28/00, C23C 14/34, C25C 3/34

(54) **HIGH-PURITY ERBIUM, SPUTTERING TARGET COMPRISING HIGH-PURITY ERBIUM, METAL GATE FILM HAVING HIGH-PURITY ERBIUM AS MAIN COMPONENT THEREOF, AND PRODUCTION METHOD FOR HIGH-PURITY ERBIUM**

(30) Priority: 30.06.2011 JP 2011145681
(71) Applicant: JX Nippon Mining & Metals Corporation, Tokyo 100-8164 (JP)
(72) Inventor: TAKAHATA Masahiro, Kitaibaraki-shi Ibaraki 319-1535 (JP)
(74) Representative: Hoarton, Lloyd Douglas Charles
(86) International application number: PCT/JP2011/071140
(87) International publication number: WO 2013/001661

(57) **Abstract**

High-purity erbium having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, other transition metal elements in a total amount of 10 wtppm or less, and U and Th as radioactive elements each in an amount of 10 wtppb or less. An object of this invention is to provide a method of highly purifying erbium, which has a high vapor pressure and is difficult to refine in a molten state, as well as technology for efficiently and stably providing high-purity erbium obtained with the foregoing method, a sputtering target made of high-purity erbium, and a metal gate film having high-purity erbium as a main component thereof.

## Description

### Technical Field

The present invention relates to a method of highly purifying erbium, which has a high vapor pressure and is difficult to refine in a molten state, high-purity erbium obtained thereby, a sputtering target made of high-purity erbium, and a metal gate film having high-purity erbium as a main component thereof.

### BACKGROUND ART

While erbium (Er) is a rare earth element, as a mineral source it is contained in the earth's crust as a mixed composite oxide. Although rare earth elements are given this name because they are separated from relatively rare existing minerals, they are not that rare when viewed in relation to the entire crust.

Erbium's atomic number is 68, and it is a gray-colored metal having an atomic weight of 167.3 and comprising a hexagonal close-packed structure. Erbium has a melting point of 1530°C, a boiling point of 2860°C, and a density of 9.07 g/cm³. Erbium's surface is oxidized in the air, it gradually melts in water, and it is soluble in acid. Erbium has superior corrosion resistance and wear resistance properties, shows high paramagnetic property, and generates oxides (Er₂O₃) at high temperatures.

With rare earth elements, it is generally said that compounds with the oxidation number 3 are stable, and erbium is also trivalent. In recent years, research and development are being promoted for using erbium as an electronic material such as a high dielectric constant (High-k) material or a metal gate material or the like, and is a metal that is attracting attention.

Nevertheless, erbium metal has a problem in that it is easily oxidized during refining, and a high-purity erbium product did not exist since its high purification was difficult.

Moreover, erbium has been used as a magnetic refrigerant material, but since its use as an electronic component was not considered, it cannot be said that it was a metal that attracted much attention. Accordingly, there are not many documents relating to practical methods of extracting erbium. Some reference documents are listed below, but they merely describe erbium as one of the elements in the extraction of rare earth metals.

Disclosed is technology of manufacturing rare earth elements of Sm, Eu, Yb by mixing the oxide powders of Sm, Eu, Yb and misch metal into a briquette, and thermally reducing this in a vacuum with the misch metal as the reduction material. The misch metal is previously subject to hydrogenation treatment to obtain powdery hydrogenated misch metal, and this is mixed and molded into a briquette in order to prevent the oxidization and combustion during the pulverization process of the misch metal (for example, refer to Patent Document 1).

In this example, while there is a scheme in the use of misch metal as the reduction material, it does not aim for higher purification, and there is a problem in that there is a limit in obtaining high purification.

Proposed is technology of eliminating slag from a rare earth metal by reducing halide of the rare earth metal with calcium or calcium hydride, placing a slag separating jig in molten slag, solidifying the slag, and removing the slag together with the jig. As the rare earths, lanthanum, cerium, praseodymium, and neodymium are selected (for example, refer to Patent Document 2). Since this technology is unable to sufficiently eliminate the slag, there is a problem in that it is difficult to achieve high purification.

Proposed is a manufacturing method of rare earth metals by adding a reducing agent to a fluoride raw material of rare earth metal and performing thermal reduction of heating the mixture at high temperature. As the fluoride raw material of rare earth metals, a mixed composition comprising fluorides of rare earth metals and lithium fluoride, or a mixed composition added with one or more types of barium fluoride and calcium fluoride is used.

In this case, the use of a fused-salt electrolysis bath is proposed, and describes that the oxygen content will become 1000 ppm (for example, refer to Patent Document 3). While this technology is based on the use of a solvent bath of fused-salt electrolysis, there are problems in that there is contamination caused by the used salt and contamination caused by the device, and the effect of oxygen elimination is also insufficient. There is also the problem of lithium, barium, calcium and so on being included as impurities.

Proposed is mixing a mixed composition of fluoride and lithium fluoride of rare earth metals or a mixed composition added with one or more types of barium fluoride and calcium fluoride, and rare earth metals, and heating and melting the mixture to extract rare earths. As the rare earths, thermally reduced commercial rare earths are used, and as the mixed composition a fused-salt electrolysis solvent bath for manufacturing alloy of rare earth metals and iron group transition metals is used.

It is described that high-purity rare earth metals in which the oxygen content is 300 ppm or less, and with few impurities such as calcium, lithium and fluorine, can be obtained (for example, refer to Patent Document 4). This technology is also based on the use of a solvent bath of fused-salt electrolysis, and there are problems in that there is contamination caused by the used salt and contamination caused by the device, and the effect of oxygen elimination is also insufficient. There is also the problem of lithium, barium, calcium and so on being included as impurities.

Proposed is a refining method for obtaining high-purity rare earths by adding Mg or Zn to rare earth metals containing Ta, which is an impurity, melting the mixture in a crucible, solidifying this, eliminating the high Ta-containing portion existing at the bottom of the crucible, and performing vacuum distillation to the low Ta-containing portion (for example, refer to Patent Document 5). Nevertheless, there is a problem in that the added metals are included as impurities and, since the elimination of Ta is also insufficient, there is a problem in that the level of high purification is low.

As shown in the foregoing documents, the effect of refining erbium is not necessarily sufficient, and in particular only a handful of documents seek the reduction of oxygen. Among those that do, there is a problem in that the reduction of oxygen is insufficient. In addition, methods that adopt the use of fused-salt electrolysis entail a complicated process, and there is a problem in that the refining effect is insufficient. Accordingly, the current situation is that there is no efficient and stable manufacturing method of obtaining high-purity erbium that is a high-melting point metal, has a high vapor pressure, and in which refining is difficult in a molten state.

In light of the above, the present Applicant proposed obtaining high-purity erbium by mixing coarse erbium oxide with reducing metals, thereafter heating the obtained product in a vacuum to reduce and distill erbium, and additionally melting the reduced and distilled erbium in an inert atmosphere.

In the foregoing case, it was possible to achieve a considerable effect of obtaining high-purity erbium having a purity of 4N or higher excluding rare earth elements and gas components, having an oxygen content of 200 wtppm or less, and containing respective elements of alkali metals each in an amount of 10 wtppm or less, respective elements of transition metals each in an amount of 100 wtppm or less, and radioactive elements each in an amount of 5 wtppb or less (refer to Patent Document 6). Nevertheless, in order to further increase the purity, it is necessary to repeat the distillation process, and there is a problem in that the yield will consequently deteriorate.

Moreover, in the foregoing case, while La as a transition metal is used as the reducing agent, La gets mixed in by necessity. Accordingly, another problem arises in that such La needs to be eliminated. Accordingly, further improvements were demanded with the Patent Documents.

Meanwhile, in cases of using erbium as a sputtering target, from the necessity of producing a target with low generation of particles during sputtering and which enables favorable uniformity of the sputtered film, proposed was an invention of further increasing the purity of the erbium target and causing the average crystal grain size of the structure to be 1 to 20 mm (refer to Patent Document 7).

The object of this invention in itself was to reduce the particles and improve the uniformity of the sputtered film and, since a high-purity level of 4N was achieved, this invention was suitable for achieving its object and was an effective invention. Nevertheless, due to the breakthrough in erbium targets, further increase in purity is being demanded.

### [Prior Art Documents]

### Patent Documents

Patent Document 1: JP-A-S61-9533
Patent Document 2: JP-A-S63-11628
Patent Document 3: JP-A-H7-90410
Patent Document 4: PCT (WO) 1995-90411
Patent Document 5: JP-A-H8-85833
Patent Document 6: WO2010/087227
Patent Document 7: JP-A-2009-001866

### SUMMARY OF THE INVENTION

### [Problems to be Solved by the Invention]

An object of this invention is to provide a method of highly purifying erbium, which has a high vapor pressure and is difficult to refine in a molten state, as well as technology for efficiently and stably providing high-purity erbium obtained with the foregoing method, a sputtering target made of high-purity erbium, and a metal gate film having high-purity erbium as a main component thereof.

### [Means for Solving the Problems]

In order to achieve the foregoing object, as a result of intense study, the present inventors discovered that it is possible to provide a method of stably producing high-purity erbium, having an even higher purity, by subjecting a coarse raw material to molten salt electrolysis, and subjecting the obtained electrodeposit to distillation and refining. The present inventors consequently discovered that, based on the foregoing production method, it is also possible to obtain high-purity erbium, a sputtering target made of high-purity erbium, and a metal gate film having high-purity erbium as a main component thereof.

The present invention provides the following invention based on the foregoing discovery.
1) High-purity erbium having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, other transition metal elements in a total amount of 10 wtppm or less, and U and Th as radioactive elements each in an amount of 10 wtppb or less.
2) A high-purity erbium sputtering target having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, other transition metal elements in a total amount of 10 wtppm or less, and U and Th as radioactive elements each in an amount of 10 wtppb or less.
3) A metal gate film having, as its main component, high-purity erbium having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, other transition metal elements in a total amount of 10 wtppm or less, and U and Th as radioactive elements each in an amount of 10 wtppb or less.
   The present invention additionally provides:
4) A method of producing high-purity erbium, wherein coarse erbium is subject to molten salt electrolysis and an electrodeposit obtained thereby is subject to distillation so as to obtain high-purity erbium having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, other transition metal elements in a total amount of 10 wtppm or less, and U and Th as radioactive elements each in an amount of 10 wtppb or less.
5) The method of producing high-purity erbium according to 4) above, wherein molten salt is prepared using potassium chloride (KCi), lithium chloride (LiCl), erbium chloride (ErCl) and erbium (Er) raw materials, and the molten salt electrolysis is performed at a bath temperature of 700°C or higher and 900°C or less.
6) The method of producing high-purity erbium according to 4) or 5) above, wherein tantalum (Ta) is used as an anode and tantalum (Ta) or titanium (Ti) is used as a cathode of the molten salt electrolysis for performing electrolysis.
7) The method of producing high-purity erbium according to any one of 4) to 6) above, wherein, in the molten salt electrolysis, Al, Fe, Cu, Ta, and W are eliminated for reducing contents thereof.
8) The method of producing high-purity erbium according to any one of 4) to 7) above, wherein, upon subjecting the electrodeposit to distillation, a distillation temperature is maintained at 700°C or higher and 1200°C or less in first distillation to eliminate impurities having a higher vapor pressure than erbium, and thereafter a distillation temperature is maintained at 1550°C or higher and 2750°C or less in second distillation to distill erbium itself.
   As described above, upon performing the first distillation, a heating furnace is used to perform vacuum heating, and metals and salt are isolated based on the vapor pressure difference and, under normal circumstances, the temperature thereof is set to 700°C or higher and 1200°C or less. While the holding time is set to 10 to 20 h, the holding time can be suitably adjusted depending on the amount of raw material. Moreover, upon performing the second distillation, a similar heating furnace is used to perform vacuum heating, and erbium is evaporated and refined and, under normal circumstances, the temperature thereof is set to 1550°C or higher and 2750°C or less. While the holding time is set to 10 to 20 h, the holding time can be suitably adjusted depending on the amount of raw material.
9) The method of producing high-purity erbium according to 8) above, wherein, in the first distillation, impurities having a high vapor pressure including Li, Na, K, Ca, and Mg are eliminated for reducing impurity contents thereof.
10) The method of producing high-purity erbium according to 8) above, wherein, in the second distillation, erbium is distilled, and impurities having a low vapor pressure including Ta and Ti are isolated.

### [Effect of the Invention]

The present invention yields superior effects of being able to provide a method of facilitating the high purification of erbium, which has a high vapor pressure and is difficult to refine in a molten state, as well as technology for efficiently and stably providing high-purity erbium, a sputtering target made of high-purity erbium, and a metal gate film having high-purity erbium as a main component thereof.

### BRIEF DESCRIPTION OF THE DRAWING

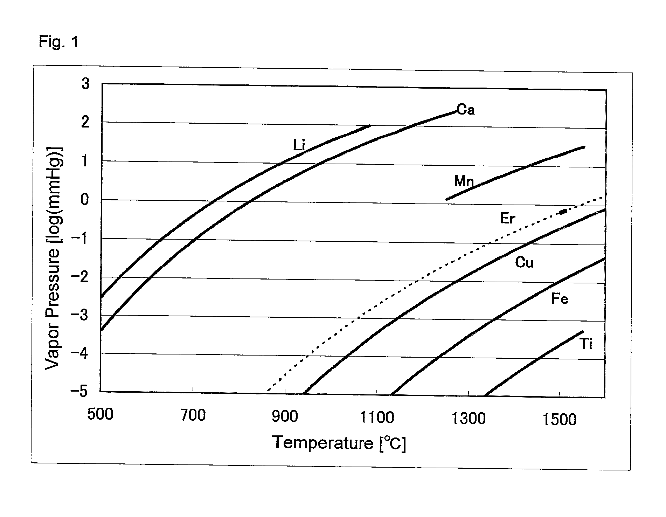

Fig. 1 is a diagram showing the vapor pressure of Er and other metal elements.

### DETAILED DESCRIPTION OF THE INVENTION

As described above, the high-purity erbium of the present invention has a purity of 5N or higher excluding rare earth elements and gas components, and contains Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, other transition metal elements in a total amount of 10 wtppm or less, and U and Th as radioactive elements each in an amount of 10 wtppb or less, and the high-purity erbium obtained as described above is a novel material, and is covered by the present invention.

When the amount of impurities excluding rare earth elements and gas components exceeds 10 wtppm, it is desirable to preferentially reduce the impurities that can be easily reduced so as to maintain an overall purity level of 5N.

The erbium obtained by the foregoing distillation is melted in a vacuum and solidified into an ingot. This ingot can be cut into a prescribed size and subject to a grinding process in order to form a sputtering target.

Accordingly, it is possible to obtain a high-purity erbium sputtering target having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, other transition metal elements in a total amount of 10 wtppm or less, and U and Th as radioactive elements each in an amount of 10 wtppb or less.

In addition, by sputtering the foregoing target, it is possible to form on a substrate a metal gate film having, as its main component, high-purity erbium having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, other transition metal elements in a total amount of 10 wtppm or less, and U and Th as radioactive elements each in an amount of 10 wtppb or less.

Moreover, it is also possible to prepare a sintered compact sputtering target by using the foregoing high-purity erbium or a mixture obtained by mixing the foregoing high-purity erbium with alloys of other metals or compounds or other ceramics, and subsequently use this target to prepare a metal gate film having the foregoing high-purity erbium as a main component thereof. In the foregoing cases, it should be understood that the composition of the high-purity erbium will be reflected in the obtained sputtering target and metal gate film.

The foregoing sputtering target and metal gate film are also novel materials, and are covered by the present invention.

The present invention is able to use a raw material of crude erbium having a purity level of 3N or lower as the erbium raw material for high purification. Normally, this raw material contains Na, K, Ca, Mg, Fe, Cr, Ni, O, C, N and so on as primary impurities excluding rare earth elements. Moreover, impurities such as Ta and W also get mixed from the crucible material which melts.

Upon producing the high-purity erbium of the present invention, coarse erbium is subject to molten salt electrolysis and an electrodeposit obtained thereby is subject to distillation so as to obtain high-purity erbium having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, other transition metal elements in a total amount of 10 wtppm or less, and U and Th as radioactive elements each in an amount of 10 wtppb or less.

Upon performing the foregoing molten salt electrolysis, it is effective to prepare the molten salt using potassium chloride (KCl), lithium chloride (LiCl), erbium chloride (ErCl₃) and erbium (Er) raw materials, and performing the molten salt electrolysis at a bath temperature of 700°C or higher and 900°C or less. While the present invention is not limited to the above, it could be said that the foregoing method is a preferred method. The reason why the bath temperature is set to 700°C or higher and 900°C or less is in order to efficiently perform the molten salt electrolysis.

It is possible to use tantalum (Ta) as an anode and use tantalum (Ta) or titanium (Ti) as a cathode of the molten salt electrolysis for performing electrolysis. The selection of materials in the foregoing case may be arbitrarily made in consideration of the relation of production costs and contaminating substances.

In the foregoing molten salt electrolysis, Al, Fe, Cu, Ta, and W can be eliminated for reducing contents thereof, and molten salt electrolysis is extremely effective for eliminating these impurities. The reduction of elements of Al, Fe, Cu, Ta, and W is effective for lowering the leak current and increasing the pressure resistance upon preparing a thin film from the erbium target.

Moreover, upon subjecting the electrodeposit to distillation, a distillation temperature is maintained at 700°C or higher and 1200°C or less in first distillation to eliminate impurities having a higher vapor pressure than erbium.

The reason why the first distillation is performed at a temperature of 700°C or higher is in order to effective eliminate the impurities, and the reason why the first distillation is performed at a temperature of 1200°C or less is in order to reduce the loss of erbium caused by evaporation. In this first distillation, it is possible to effectively eliminate the impurities having a high vapor pressure including Li, Na, K, Ca, and Mg.

Subsequently, second distillation is performed as needed by maintaining the temperature at 1550°C or higher and 2750°C or less to distill erbium itself in order to obtain erbium having an even higher purity level. This second distillation is performed when higher purification of erbium is required.

In the foregoing second distillation, erbium is distilled and erbium with improved purity is stored in the capacitor. This distillate is melted in a crucible, and solidified into an ingot.

The melting and solidification process is preferably performed in an inert atmosphere. It is thereby possible to suppress the rise in oxygen content. While it is also possible to perform the melting and solidification process in a vacuum, since the yield tends to become inferior, it is desirable to perform the process in an inert atmosphere as described above. Nevertheless, the present invention is not denying the performance of the foregoing process in a vacuum.

The reason why the second distillation is performed at a temperature of 1550°C or higher is in order to effectively distill erbium, and it is thereby possible to isolate impurities having a low vapor pressure including Ta and Ti. The reason why the second distillation is performed at a temperature of 2750°C or less is in order to avoid heat loss, and effectively isolate erbium from substances having a low vapor pressure.

The relation of the temperature and the vapor pressure of elements as representative examples of impurity elements contained in erbium is shown in Fig. 1. Based on Fig. 1, it can be said that it is difficult to eliminate Cu, which is approximate to erbium, based on distillation. Accordingly, Cu needs to be eliminated prior to performing distillation.

Based on the above, it is possible to cause the respective contents of alkali metals and alkali rare earth metals to be 1 wtppm or less. The foregoing alkali metals and alkali rare earth metals lithium (Li), sodium (Na), potassium (K), rubidium (Rb), cesium (Cs), and francium (Fr), and the foregoing alkali rare earth metal elements are calcium (Ca), barium (Ba), beryllium (Be), and magnesium (Mg).

These metal elements are electrically positive and, for example, if erbium is used as an electronic component, there is a problem in that the elements with a small atomic radius will easily move within the device, and destabilize the properties of the device. While inclusion up to 10 wtppm is tolerated as the total amount of the respective metal elements, such inclusion should be reduced as much as possible, and the content of the respective metal elements is preferably 1 wtppm or less.

The foregoing transition metal elements are metals that belong to groups 3 to 11 of the periodic table, and representative examples thereof are titanium (Ti), vanadium (V), chromium (Cr), manganese (Mn), iron (Fe), cobalt (Co), nickel (Ni), copper (Cu), and zinc (Zn). These elements induce the increase of the leak current and cause the deterioration in pressure resistance. While inclusion up to 1 wtppm or less is tolerated as the respective contents of Fe and Cu, and inclusion up to 10 wtppm or less is tolerated as the total amount of transition metal elements other than those described above, such inclusion should be reduced as much as possible.

While the present invention does not specifically prescribe radioactive elements, radioactive elements can be similarly reduced. Representative examples of radioactive elements are uranium (U), actinium (Ac), thorium (Th), lead (Pb), and bismuth (Bi), and these radioactive elements cause a soft error of the accumulated charge of the memory cells becoming inverted. Accordingly, it is necessary to reduce the amounts of such radioactive elements as well as limit the alpha dose that is generated from such elements. While inclusion up to 20 wtppb can be tolerated as the total amount of radioactive elements, such inclusion should be reduced as much as possible.

As described above, the respective elements can be individually analyzed and managed, and the respective contents of these elements are preferably 10 wtppb or less, and more preferably 1 wtppb or less. In particular, it is necessary to reduce U and Th which have a significant influence.

As a result of measuring the alpha dose of the target of the present invention with a gas flow proportional counter as the measuring device, the alpha dose was less than 0.01 cph/cm².

The reason why the rare earth elements are excluded from the high-purity erbium as described above is because, since the other rare earths themselves have similar chemical properties as erbium, it is technically difficult to eliminate such rare earth elements upon producing high-purity erbium, and, even if they are included as impurities, the properties will not be affected significantly since their properties are approximate.

Due to the foregoing circumstances, the inclusion of other rare earths is silently approved to a certain degree, but it goes without saying that it is desirable to reduce the inclusion of such other rare earths as much as possible in order to improve the properties of the erbium itself.

Moreover, the reason why the purity is 5N or higher excluding gas components is because the elimination of gas components is difficult, and, if such gas components are counted, it will no longer be a rough indication of the improvement of purity. In addition, generally speaking, in many cases the existence of small amounts of gas components is usually harmless in comparison to other impurity elements.

When forming a thin film of an electronic material such as a gate insulation film or a thin film for use as a gate electrode, such thin film is often produced by sputtering, and sputtering is a superior method as a means for forming a thin film. Accordingly, it is effective to use the foregoing erbium ingot to produce a high-purity erbium sputtering target.

The target can be produced with standard processes such as forging, rolling, cutting and finishing, i.e. polishing. In particular, there is no particular limitation in the production process, and the production process may be arbitrarily selected.

While the high-purity erbium having the foregoing composition can be used as is as the metal gate film, it may also be mixed with other gate materials or formed as an alloy or a compound. This can be achieved by the simultaneous sputtering with the target of other gate materials or sputtering using a mosaic target. The present invention also covers the foregoing aspects. While the impurity content will change depending on the impurity contained in the raw material, the respective impurities can be adjusted to be within the foregoing range by adopting the method described above.

The present invention provides a method of highly purifying erbium, technology capable of efficiently and stably providing high-purity erbium based on the foregoing method, a sputtering target made of high-purity material erbium, and a thin film,for use as a gate electrode having high-purity material erbium as a main component thereof.

### [Examples]

The present invention is now explained in detail with reference to the Examples. These Examples are merely illustrative, and the present invention shall in no way be limited thereby. In other words, various modifications and other embodiments based on the technical spirit claimed in the claims shall be covered by the present invention as a matter of course.

### (Example 1)

As the raw material, erbium (Er) having a purity of 2N5 to 3N excluding rare earths was used, and molten salt electrolysis was performed in the following conditions.
(1) Bath composition:
KCI: 8 kg
LiCl: 6 kg
ErCl₃: 4 kg
Er raw material: 5 kg

(2) Bath temperature: 800°C
(3) Anode: Ta rod
(4) Cathode: Ta or Ti rod was used for the electrodeposited part.
With the molten salt electrolysis using the Ta cathode, it was discovered that the elimination effect of Al, Fe, Cu, Ta, W and the like was high. Moreover, while similar effects can be obtained when the Ti cathode is used, Ti is not suitable for repeated use since the corrosion of the Ti cathode will advance after being used several times and cause contamination. However, by increasing the frequency of replacement such as by replacing the Ti cathode once to several times after using it, it can be used as a cathode.
(5) Current density: 0.50 A/cm² While the current density may be suitably selected, it could be said that the foregoing current density is preferably used since the purity will deteriorate if the current density is any higher.
(6) Electrolysis time: It is possible to obtain an electrodeposited weight of 100 g in 6 hours. The current efficiency is roughly 70%.
(7) Voltage: While the voltage was set to roughly 1.0 V, there is no particular limitation.
(8) Distillation
1) First distillation
The first distillation was performed at distillation temperature of 1000°C or less.
It was possible to eliminate Li, Na, K (caused by salt), Ca, and Mg (contamination from the raw material, crucible material and so on).
2) Second distillation
Er was distilled at a distillation temperature of 1500°C.
It was thereby possible to eliminate Ta and so on (contamination from the furnace material).
As a result of performing distillation, Fe, U, Th, Na, K, Ca, Mg and gas components (carbon) can be effectively eliminated.

**Table 1**

| Raw Material | | | | Example 1 | Example 2 | Comparative Example 1 | Comparative Example 2 | Comparative Example 3 |
|---|---|---|---|---|---|---|---|---|
| Li | <0.01 ∼ 1.1 | | Li | <0.01 | <0.01 ∼ 0.02 | <0.01 ∼ 2.1 | 0.5 | <0.01 |
| Na | <0.05 ∼ 0.93 | | Na | <0.01 | <0.01 | 0.05 ∼ 0.2 | <0.05 | 0.09 |
| Mg | <0.05 ∼ 7.2 | | Mg | <0.05 | <0.05 ∼ 0.08 | <0.5 ∼ 0.16 | <0.05 | 0.13 |
| Al | 65 ∼ 330 | | Al | <0.05 | 0.16 ∼ 0.22 | 37 ∼ 2000 | 66 | 130 |
| Si | 0.06 ∼ 150 | | Si | 0.1 ∼ 0.52 | 0.54 ∼ 0.85 | 0.14 ∼ 1.4 | 6.4 | 180 |
| K | <0.1 ∼ 2.6 | | K | <0.1 | <0.1 | <0.1 ∼ 0.4 | <0.1 | <0.45 |
| Ca | <0.1 ∼ 100 | | Ca | <0.1 | <0.1 ∼ 0.39 | 1 ∼ 340 | 2.7 | 2.3 |
| Ti | 0.67 ∼ 2.5 | | Ti | <0.01 | 0.21 ∼ 0.47 | 10 ∼ 130 | 350 | 56 |
| Fe | 29 ∼ 3500 | | Fe | 0.08 ∼ 0.24 | 0.29 ∼ 0.48 | 32 ∼ 600 | 300 | 380 |
| Cu | 6.9 ∼ 460 | | Cu | 0.07 ∼ 0.16 | 0.31 ∼ 0.65 | 100 ∼ 500 | 110 | 47 |
| Ta | <1 ∼ 160 | | Ta | <1 | <1 | <1 | 290 | 5300 |
| W | <10 ∼ 4500 | | W | <10 | <10 | <10 | <10 | 3600 |
| Th | <0.005 ∼ 0.44 | | Th | <0.001 | <0.001 | <0.001 | 0.02 | 0.02 |
| U | <0.005 ∼ 0.38 | | U | <0.001 | <0.001 | <0.001 | <0.001 | <0.001 |
| C | 300 ∼ 2400 | | C | 60 ∼ 150 | 16 ∼ 120 | 250 ∼ 300 | 410 | 340 |

| | | | | | | | | |
|---|---|---|---|---|---|---|---|---|
| Unit: wtppm | | | | | | | | |

(9) Melting
The erbium distillate accumulated in the capacitor during the foregoing distillation processes was removed, and a water-cooled Cu crucible was used to perform induction melting in an Ar atmosphere, and the resulting product was solidified into an ingot.

Based on the above, in this Example, molten salt electrolysis and two distillation processes (first distillation and second distillation described above) were performed. It was thereby possible to produce high-purity erbium having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, and other transition metal elements in a total amount of 10 wtppm or less.

The results are shown in Table 1. As evident from Table 1, the results were Fe: 0.08 to 0.24 wtppm, U: <1 wtppb, Th: <1 wtppb, Na: <0.01 wtppm, K: <0.1 wtppm, Ca: <0.1 wtppm, Mg: <0.05 wtppm, Cu: 0.07 to 0.16 wtppm, Al: <0.05 wtppm, and C: 60 to 150 wtppm, and thus it was possible to considerably reduce these impurities.

The sputtering target obtained from the foregoing ingot was able to similarly maintain high-purity and, by sputtering the obtained sputtering target, it was possible to form, on a substrate, a high-purity erbium thin film having uniform characteristics.

### (Example 2)

As the raw material, erbium (Er) having a purity of 2N5 to 3N excluding rare earths was used, and molten salt electrolysis was performed in the following conditions.
(1) Bath composition:
   KCI: 10 kg
   LiCl: 8 kg
   ErCl₃: 6 kg
   Er raw material: 7 kg
(2) Bath temperature: 800°C
(3) Anode: Ta rod
(4) Cathode: Ta or Ti rod was used for the electrodeposited part.
   With the molten salt electrolysis using the Ta cathode, it was discovered that the elimination effect of Al, Fe, Cu, Ta, W and the like was high. Moreover, while similar effects can be obtained when the Ti cathode is used, Ti is not suitable for repeated use since the corrosion of the Ti cathode will advance after being used several times and cause contamination. However, by increasing the frequency of replacement such as by replacing the Ti cathode once to several times after using it, it can be used as a cathode.
(5) Current density: 0.50 A/cm²
   While the current density may be suitably selected, it could be said that the foregoing current density is preferably used since the purity will deteriorate if the current density is any higher.
(6) Electrolysis time: It is possible to obtain an electrodeposited weight of 100 g in 6 hours. The current efficiency is roughly 70%.
(7) Voltage: While the voltage was set to roughly 1.0 V, there is no particular limitation.
(8) Distillation
   1) First distillation
      The first distillation was performed at distillation temperature of 1000°C or less.
      It was possible to eliminate Li, Na, K caused by salt, Ca, and Mg (contamination from the raw material, crucible material and so on).
   2) Second distillation
      Er was distilled at a distillation temperature of 1500°C.
      It was thereby possible to eliminate Ta and so on (contamination from the furnace material).
      As a result of performing distillation, Fe, U, Th, Na, K, Ca, Mg and gas components (carbon) can be effectively eliminated.
(9) Melting
   The erbium distillate accumulated in the capacitor during the foregoing distillation processes was removed, and a water-cooled Cu crucible was used to perform plasma arc melting in an Ar atmosphere, and the resulting product was solidified into an ingot.

Based on the above, in Example 2, molten salt electrolysis and two distillation processes of first distillation and second distillation described above were performed. It was thereby possible to produce high-purity erbium having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, and other transition metal elements in a total amount of 10 wtppm or less.

The results are shown in Table 1. As evident from Table 1, the results were Fe: 0.29 to 0.48 wtppm, U: <1 wtppb, Th: <1 wtppb, Na: <0.01 wtppm, K: <0.1 wtppm, Ca: <0.1 to 0.39 wtppm, Mg: <0.05 to 0.08 wtppm, Cu: 0.31 to 0.65 wtppm, Al: <0.16 to 0.22 wtppm, and C: 16 to 120 wtppm, and thus it was possible to considerably reduce these impurities.

The sputtering target obtained from the foregoing ingot was also able to maintain a high-purity level, and it was possible to form a high-purity erbium thin film with uniform characteristics on a substrate by sputtering the foregoing sputtering target.

### (Comparative Example 1)

Comparative Example 1 is a case where, as described later, distillation was only performed once for the refining process.

Foremost, as the raw material, erbium (Er) having a purity of 2N5 to 3N excluding rare earths was used, and Er was distilled at a distillation temperature of 1500°C.

The results are shown in Table 1. As evident from Table 1, the results were Fe: 32 to 600 wtppm, U: <1 wtppb, Th: <1 wtppb, Na: 0.05 to 0.2 wtppm, K: <0.1 to 0.4 wtppm, Ca: <1 to 340 wtppm, Mg: <0.5 to 0.16 wtppm, Cu: 100 to 500 wtppm, Al: 37 to 2000 wtppm, and C: 250 to 300 wtppm.

Accordingly, when distillation is performed only once, it can be understood that it is difficult to effectively eliminate Al, Ti, Fe, and Cu. Otherwise, it was also discovered that the elimination effect of Ca, Mg, and C is also low.

### (Comparative Example 2)

Comparative Example 2 is a case where, as described later, electrolysis and distillation are not performed, and only plasma arc melting is performed for the refining process.

Foremost, as the raw material, erbium (Er) having a purity of 2N5 to 3N excluding rare earths was used, a water-cooled Cu crucible was used to perform plasma arc melting in an Ar atmosphere, and the resulting product was solidified into an ingot.

The results are shown in Table 1. As evident from Table 1, the results were Fe: 300 wtppm, U: <1 wtppb, Th: 20 wtppb, Na: <0.05 wtppm, K: <0.1 wtppm, Ca: 2.7 wtppm, Mg: <0.05 wtppm, Cu: 110 wtppm, Al: 66 wtppm, and C: 410 wtppm. Accordingly, in a case where distillation is not performed and only plasma arc melting is performed, while Li, Na, Mg, K, and Ca are refined, the other impurities could not be sufficiently eliminated. In the foregoing case, since erbium is strongly affected by the purity of the raw material, there was a problem in that variation in the purity would increase.

### (Comparative Example 3)

Comparative Example 3 is a case where, as described later, electrolysis and distillation are not performed, induction melting and plasma arc melting are also not performed, and only EB melting is performed for the refining process.

Foremost, as the raw material, erbium (Er) having a purity of 2N5 to 3N excluding rare earths was used, a water-cooled Cu crucible was used to perform EB melting in a vacuum, and the resulting product was solidified into an ingot.

The results are shown in Table 1. As evident from Table 1, the results were Fe: 380 wtppm, U: <1 wtppb, Th: 20 wtppb, Na: <0.09 wtppm, K: <0.45 wtppm, Ca: 2.3 wtppm, Mg: 0.13 wtppm, Cu: 47 wtppm, Al: 130 wtppm, and C: 340 wtppm.

Accordingly, in a case where electrolysis, distillation, induction melting and plasma arc melting are not performed, and only EB melting is performed for the refining process, while Li, Na, Mg, K, and Ca are refined, the other impurity elements listed in Table 1 are not volatilized (do not scatter), and rather become concentrated, and the results were inferior since the impurities become concentrated from the raw material. Moreover, since Er itself has a high vapor pressure, it becomes volatilized and deteriorates the yield to be roughly 50%; and the results were inferior with respect to this point also.

### (Comprehensive Evaluation of Results of Examples)

While not specifically illustrated in the foregoing Examples, it was confirmed that the intended results can be obtained if the temperature upon performing the distillation of erbium is within the range of 1550 to 2750°C.

Moreover, while not specifically illustrated in the Examples, when a raw material having a purity level of 3N or less was used, it was confirmed that high-purity erbium having a purity level of 5N could be obtained in all cases under the refining conditions of the present invention.

In addition, it was confirmed that it is possible to obtain high-purity erbium having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, other transition metal elements in a total amount of 10 wtppm or less, and U and Th as radioactive elements each in an amount of 10 wtppb or less.

The foregoing high-purity erbium is able to maintain its purity even when processed into a target, and it was therefore also possible to obtain a high-purity erbium sputtering target having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, other transition metal elements in a total amount of 10 wtppm or less, and U and Th as radioactive elements each in an amount of 10 wtppb or less.

In addition, even in cases where the foregoing sputtering target was deposited onto a substrate, the purity of the target was reflected, and it was confirmed that it is possible to obtain a metal gate film having, as its main component, high-purity erbium having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, other transition metal elements in a total amount of 10 wtppm or less, and U and Th as radioactive elements each in an amount of 10 wtppb or less.

The foregoing is not indicated in the Examples in order to avoid redundancy and complication, but was confirmed as specific conditions.

### [Industrial Applicability]

The method of producing high-purity erbium according to the present invention can resolve the problems encountered in conventional methods; namely, that erbium has a high melting point and vapor pressure and is difficult to refine in a molten state, and facilitates the high purification of erbium. The present invention yields superior effects in being able to provide the specific method thereof, as well as technology for efficiently and stably providing high-purity erbium obtained with the foregoing method, a sputtering target made of high-purity erbium, and a metal gate film mainly comprising high-purity erbium. In particular, the present invention is useful as materials of a gate insulation film or a thin film for use as a gate electrode or high dielectric constant (High-k) materials since they will not, as electronic materials to be disposed near the silicon substrate, deteriorate or disturb the functions of electronic devices.

## Claims

1. High-purity erbium having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, other transition metal elements in a total amount of 10 wtppm or less, and U and Th as radioactive elements each in an amount of 10 wtppb or less,

2. A high-purity erbium sputtering target having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, other transition metal elements in a total amount of 10 wtppm or less, and U and Th as radioactive elements each in an amount of 10 wtppb or less.

3. A metal gate film having, as its main component, high-purity erbium having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, other transition metal elements in a total amount of 10 wtppm or less, and U and Th as radioactive elements each in an amount of 10 wtppb or less.

4. A method of producing high-purity erbium, wherein coarse erbium is subject to molten salt electrolysis and an electrodeposit obtained thereby is subject to distillation so as to obtain high-purity erbium having a purity of 5N or higher excluding rare earth elements and gas components, and containing Al, Fe, Cu, and Ta each in an amount of 1 wtppm or less, W in an amount of 10 wtppm or less, carbon in an amount of 150 wtppm or less, alkali metals and alkali earth metals each in an amount of 1 wtppm or less, other transition metal elements in a total amount of 10 wtppm or less, and U and Th as radioactive elements each in an amount of 10 wtppb or less.

5. The method of producing high-purity erbium according to claim 4, wherein molten salt is prepared using potassium chloride (KCI), lithium chloride (LiCl), erbium chloride (ErCl₃) and erbium (Er) raw materials, and the molten salt electrolysis is performed at a bath temperature of 700°C or higher and 900°C or less.

6. The method of producing high-purity erbium according to claim 4 or claim 5, wherein tantalum (Ta) is used as an anode and tantalum (Ta) or titanium (Ti) is used as a cathode of the molten salt electrolysis for performing electrolysis.

7. The method of producing high-purity erbium according to any one of claims 4 to 6, wherein, in the molten salt electrolysis, Al, Fe, Cu, Ta, and W are eliminated for reducing contents thereof.

8. The method of producing high-purity erbium according to any one of claims 4 to 7, wherein, upon subjecting the electrodeposit to distillation, a distillation temperature is maintained at 700°C or higher and 1200°C or less in first distillation to eliminate impurities having a higher vapor pressure than erbium, and thereafter a distillation temperature is maintained at 1550°C or higher and 2750°C or less in second distillation to distill erbium itself.

9. The method of producing high-purity erbium according to claim 8, wherein, in the first distillation, impurities having a high vapor pressure including Li, Na, K, Ca, and Mg are eliminated for reducing impurity contents thereof.

10. The method of producing high-purity erbium according to claim 8, wherein, in the second distillation, erbium is distilled, and impurities having a low vapor pressure including Ta and Ti are isolated.
